(19) Europäisches Patentamt
European Patent Office
Office européen des brevets

(11) EP 4 590 107 A1

(12) **EUROPEAN PATENT APPLICATION**

(43) Date of publication:
23.07.2025 Bulletin 2025/30

(21) Application number: 25150331.4

(22) Date of filing: 06.01.2025

(51) International Patent Classification (IPC):
H10N 10/13 (2023.01)    H10N 10/17 (2023.01)

(52) Cooperative Patent Classification (CPC):
H10N 10/13; H10N 10/17

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 17.01.2024 US 202418414652

(71) Applicant: Honeywell International Inc.
Charlotte, NC 28202 (US)

(72) Inventors:
• MUNIRAJU, Raghavendra
Charlotte, 28202 (US)
• V, Hemanth
Charlotte, 28202 (US)
• KAJJAM, Praveen Kumar
Charlotte, 28202 (US)

(74) Representative: Haseltine Lake Kempner LLP
Cheapside House
138 Cheapside
London EC2V 6BJ (GB)

(54) **EFFICIENT THERMAL ENERGY HARVESTING SYSTEM WITH INGRESS PROTECTION FOR POWERING MULTI SENSOR APPLICATIONS**

(57)    An energy harvesting system and a method of operating the energy harvesting system can include a phase change material (PCM) heat exchanger and a heat sink, wherein the heat sink is located in an energy harvesting section with the PCM heat exchanger positioned adjacent to the heat sink. A thermoelectric generator (TEG) module can be located within the energy harvesting section, such heat generated from a heat source can be pumped to the heat sink through the TEG module to produce a heat flux/thermal gradient across a hot plate and a cold plate to generate electrical energy.

FIG. 10

**Description**

TECHNICAL FIELD

Embodiments are generally related to energy harvesting methods, devices, and systems. Embodiments further relate to phase change material (PCM) and heat pipe arrangements used in energy harvesting devices and systems.

BACKGROUND

Maintenance is one of the most important aspect of running a plant or an industry. The maintenance philosophy a plant follows will determine how much downtime the plant should go through and the profit margin of the plant. The main goal of maintenance is to minimize scheduled and unscheduled downtime, improve safety and maximize the availability of production equipment. The common maintenance philosophies followed by plants and industries are reactive maintenance, preventive maintenance, and proactive Maintenance.

The proactive maintenance philosophy requires regular and frequent monitoring of the machine's health condition. The remote monitoring or equipment health monitoring requires power management to optimize the battery life that completely depends on the periodicity of sensor excitation, data processing and data communication. Larger the update interval shorter the battery life, conversely higher the battery life for larger update interval there is need to have larger battery size that increases the size and weight of the device. The larger size and weight of the device may not serve certain applications because of limited mounting space availability and cost of the device increases because of larger device size.

To power multi-variant sensor across different applications, achieving an infinite battery life is essential. This can be accomplished by either combining the battery with energy harvesting or exclusively relying on energy harvesting, aligning with sustainability objectives. In pursuit of this objective, it's crucial to enhance energy harvesting systems to broaden the scope of applications and improve update rates. Existing market solutions using conventional energy harvesting methods are plagued by sizes and weights that are too large and difficult to implement in compact integrated solutions. To integrate smaller and lighter components into a multi-sensor application, a solution lies in optimizing energy harvesting efficiency without compromising on size and weight.

BRIEF SUMMARY

The following summary is provided to facilitate an understanding of some of the features of the disclosed embodiments and is not intended to be a full description. A full appreciation of the various aspects of the embodiments disclosed herein can be gained by taking the specification, claims, drawings, and abstract as a whole.

It is, therefore, one aspect of the disclosed embodiments to provide for an improved energy harvesting method, apparatus and system.

It is another aspect of the disclosed embodiments to provide for an energy harvesting method, apparatus and system that can incorporate the use of a phase change material (PCM) / heat pipe arrangement.

It is a further aspect of the disclosed embodiments to provide for an energy harvesting method, apparatus and system that uses a PCM arrangement with a unique ingress protection (IP67) feature.

It also an aspect of the disclosed embodiments to provide for an energy harvesting method, apparatus and system that operates in the context of a battery-less, self-powered sensor node that can harvest free energy from ambient sources such as thermal and light by using advanced energy harvesting technology.

The aforementioned aspects and other objectives can now be achieved as described herein. In an embodiment, an energy harvesting system can include: a phase change material (PCM) heat exchanger and a heat sink, wherein the heat sink is located in an energy harvesting section with the PCM heat exchanger positioned adjacent to the heat sink; and a thermoelectric generator (TEG) module located within the energy harvesting section, wherein heat generated from a heat source is pumped to the heat sink through the TEG module to produce a heat flux/thermal gradient across a hot plate and a cold plate to generate electrical energy.

In an embodiment, the PCM heat exchanger can run from a first condenser to a second condenser.

An embodiment can further include a housing, wherein the heat sink located outside the housing.

In an embodiment, a sensor can be integrated with one or more of: PCM heat exchanger, the heat sink, and the TEG module.

In an embodiment, a sensor can be integrated with the PCM heat exchanger, the heat sink, and the TEG module in a single multi-variant sensor device.

In an embodiment, the single multi-variant sensor device can include ingress protection features.

In an embodiment, the aforementioned sensor may function as a battery-less self-powered sensor harvesting free energy from ambient sources using the energy harvesting system.

In an embodiment, the housing can comprise a cylindrical structure with a photovoltaic panel located at one end of the cylindrical structure and the heat sink located at the other end of the cylindrical structure.

In another embodiment, an energy harvesting system, can include: a first condenser and a second condenser; a phase change material (PCM) heat exchanger and a heat sink, wherein the PCM heat exchanger runs from the first condenser to the second condenser, the heat sink located in an energy harvesting section with the PCM heat exchanger positioned adjacent to the heat sink; and a thermoelectric generator (TEG) module located within the energy harvesting section, wherein heat generated from a heat source is pumped to the heat sink through the TEG module to produce a heat flux/thermal gradient across a hot plate and a cold plate to generate electrical energy.

In another embodiment, a method of operating an energy harvesting system, can involve: providing a phase change material (PCM) heat exchanger and a heat sink, wherein the heat sink is located in an energy harvesting section with the PCM heat exchanger positioned adjacent to the heat sink; and pumping heat generated from a heat source to the heat sink through a thermoelectric generator (TEG) module located within the energy harvesting section to produce a heat flux/thermal gradient across a hot plate and a cold plate to generate electrical energy.

BRIEF DESCRIPTION OF THE DRAWINGS

The accompanying figures, in which like reference numerals refer to identical or functionally similar elements throughout the separate views and which are incorporated in and form a part of the specification, further illustrate the present invention and, together with the detailed description of the invention, serve to explain the principles of the present invention.

FIG. 1 illustrates a schematic diagram of a thermal energy harvesting system, which may be implemented in accordance with an embodiment;

FIG. 2 illustrates a schematic diagram depicting a phase change material (heat pipe) heat exchanger system, which may be implemented in accordance with an embodiment;

FIG. 3 illustrates a side perspective view of a high-efficient thermo-electric energy harvesting apparatus, which may be implemented in accordance with an embodiment;

FIG. 4 illustrates side sectional views of the high-efficient thermo-electric energy harvesting apparatus shown in FIG. 3, in accordance with an embodiment;

FIG. 5 illustrates a reverse perspective view of a high-efficient thermo-electric energy harvesting apparatus shown in FIG. 3 and FIG. 4, in accordance with an embodiment;

FIG. 6 illustrates a bottom view of a thermoelectric generator (TEG) component, in accordance with an embodiment;

FIG. 7 illustrates a bottom view of the TEG attached to a phase change material (heat pipe), in accordance with an embodiment;

FIG. 8 illustrates a side sectional view of a high-efficient thermo-electric energy harvesting apparatus, in accordance with an embodiment;

FIG. 9 illustrates a side perspective sectional view of the high-efficient thermo-electric energy harvesting apparatus shown in FIG. 8, in accordance with an embodiment;

FIG. 10 illustrates a side cut-away view of high-efficient thermo-electric energy harvesting apparatus, which may be implemented in accordance with an embodiment;

FIG. 11 illustrates a schematic diagram depicting efficiency in a phase change material (PCM) heat pipe;

FIG. 12 illustrates a graph depicting energy efficiency in accordance with an embodiment;

FIG. 13 illustrates a graph depicting a thermal profile of a heat sink without and without PCM;

FIG. 14 illustrates a side sectional view of a high-efficient thermo-electric energy harvesting apparatus, in accordance with an alternative embodiment;

FIG. 15 illustrates a side sectional view of a high-efficient thermo-electric energy harvesting apparatus, in accordance with an alternative embodiment; and

FIG. 16 illustrates a side sectional view of a high-efficient thermo-electric energy harvesting apparatus, in accordance with yet another embodiment.

Identical or similar parts or elements in the figures may be indicated by the same reference numerals.

DETAILED DESCRIPTION

The particular values and configurations discussed in these non-limiting examples can be varied and are cited merely to illustrate one or more embodiments and are not intended to limit the scope thereof.

Subject matter will now be described more fully hereinafter with reference to the accompanying drawings, which form a part hereof, and which show, by way of illustration, specific example embodiments. Subject matter may, however, be embodied in a variety of different forms and, therefore, covered or claimed subject matter is intended to be construed as not being limited to any example embodiments set forth herein; example embodiments are provided merely to be illustrative. Likewise, a reasonably broad scope for claimed or covered subject matter is intended. Among other issues, subject matter may be embodied as methods, devices, components, or systems. Accordingly, embodiments may, for example, take the form of hardware, software, firmware, or a combination thereof. The following detailed description is, therefore, not intended to be interpreted in a limiting sense.

Throughout the specification and claims, terms may have nuanced meanings suggested or implied in context beyond an explicitly stated meaning. Likewise, phrases such as "in an embodiment" or "in one embodiment" or "in an example embodiment" and variations thereof as utilized herein may or may not necessarily refer to the same embodiment and the phrase "in another embodiment" or "in another example embodiment" and variations thereof as utilized herein may or may not necessarily refer to a different embodiment. It is intended, for example, that claimed subject matter include combinations of example embodiments in whole or in part.

In general, terminology may be understood, at least in part, from usage in context. For example, terms such as "and," "or," or "and/or" as used herein may include a variety of meanings that may depend, at least in part, upon the context in which such terms are used. Generally, "or" if used to associate a list, such as A, B, or C, is intended to mean A, B, and C, here used in the inclusive sense, as well as A, B, or C, here used in the exclusive sense. In addition, the term "one or more" as used herein, depending at least in part upon context, may be used to describe any feature, structure, or characteristic in a singular sense or may be used to describe combinations of features, structures, or characteristics in a plural sense. Similarly, terms such as "a," "an," or "the", again, may be understood to convey a singular usage or to convey a plural usage, depending at least in part upon context. Furthermore, the term "at least one" as used herein, may refer to "one or more." For example, "at least one widget" may refer to "one or more widgets."

In addition, the term "based on" may be understood as not necessarily intended to convey an exclusive set of factors and may, instead, allow for existence of additional factors not necessarily expressly described, again, depending at least in part on context.

The disclosed embodiments relate to highly efficient thermal energy harvesting that can be implemented to scavenge larger energy for lower delta temperature across the hot and cold plates of a TEG module. As will be discussed in greater detail below, the disclosed embodiments can provide for an enhanced efficiency of around 50% increase compared to conventional harvester systems/devices. Furthermore, a phase change material (PCM) / heat pipe arrangement can increase the thermal conductivity to absorb more heat from the source and dissipate more heat through a heat sink. The embodiments can be implemented in the context of a micro thermal engine system.

The embodiments additionally can use a PCM arrangement to provide a unique ingress protection (IP67) feature versus conventional harvester devices/systems that require a TEG module located outside a housing. The embodiments can be designed to be manufacturing, assembly and testing (DFMAT) friendly. The embodiments can also be implemented as a battery-less, self-powered sensor node harvesting free energy from ambient sources such as thermal and light by means of advanced energy harvesting technology. The embodiments can be adapted for use with, for example, a Multi-Variant Sensor Platform such as the Honeywell Versatilis™ Platform. The embodiments can further implement a multi-energy harvesting, multi-parametric sensing topology consolidated into a single unit for remote monitoring applications.

As will be discussed in more detail, an energy harvesting system can be implemented, which encompasses several key components. The system can include a phase change material (PCM) heat exchanger and a heat sink, both of which are contained within a housing. The PCM heat exchanger can be positioned adjacent to the heat sink. Additionally, a thermoelectric generator (TEG) module is an integral part of the system. The TEG module can play a pivotal role in the energy harvesting process, as it transfers heat from a heat source to the heat sink. This transfer generates a thermal gradient across a hot plate and a cold plate, which subsequently produces electrical energy.

Furthermore, one or more sensors can be incorporated into the system. The sensor(s) can be seamlessly integrated with the PCM heat exchanger, the heat sink, and the TEG module, effectively forming a single device. This integration ensures that the sensor is intimately connected with the core components of the energy harvesting system, allowing it to monitor and gather data in a highly efficient and synchronized manner.

Ingress protection can also be included as a feature of the embodiments. Ingress protection safeguards the system against the intrusion of foreign materials, such as dust, dirt, or moisture, which can adversely affect the system's performance and longevity. This feature ensures the system's durability and reliability, particularly when used in various environmental conditions, making it a more robust and versatile solution for energy harvesting applications.

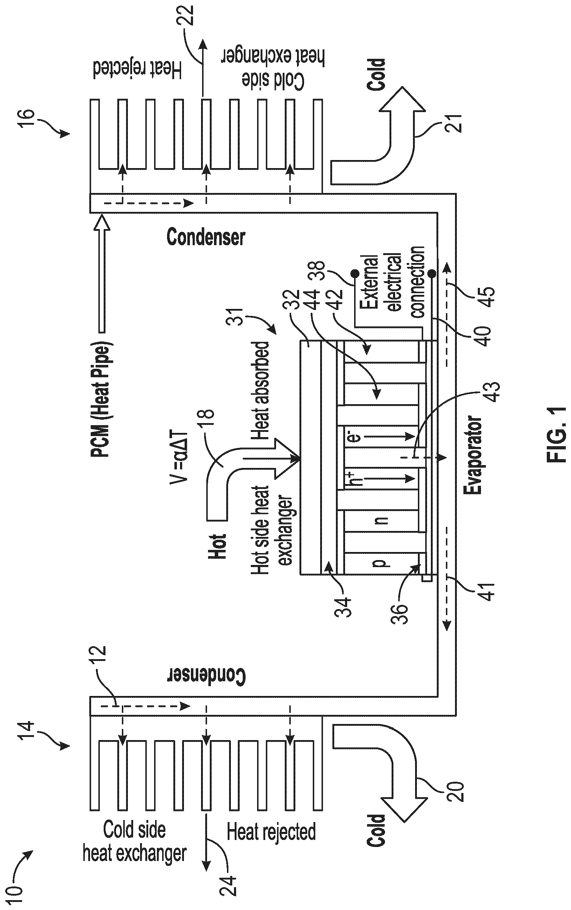

FIG. 1 illustrates a schematic diagram of a thermal energy harvesting system 10, which may be implemented in accordance with an embodiment. The configuration shown in FIG. 1 can include a PCM 12 (e.g., heat pipe) that runs from a condenser 14 to a condenser 16. An arrow 24 shown in FIG. 1 with respect to the condenser 14 indicates that the condenser 14 functions as a cold side heat exchanger wherein heat is rejected. Arrow 22 similarly indicates that the condenser 16 can function as a cold side heat exchanger wherein heat is also rejected. The arrows 20 and 21 indicates cold air flow. In FIG. 1 the PCM 12 is generally configured in a U-shaped arrangement.

A plurality of metal interconnects such as metal interconnects 36, etc., are also shown in FIG. 1, one or more of which may be electrically connected to form an electrical connection composed of electrical connections 38 and 40. The arrows 41, 43 and 45 shown in FIG. 1 indicate evaporative action (e.g., evaporator). The thermal energy harvesting system 10 further includes a hot side heat exchanger 31 wherein heat 18 is absorbed. The hot side heat exchanger includes one or more substrate layers such as substrates 32 and 34, along with a plurality of thermoelectric elements such as 42, 44, etc.

In the thermal energy harvesting system 10, the heat 18 generated from a heat source (not shown in FIG. 1) is pumped to a heat sink through a TEG module generating a larger heat flux / thermal gradient across a hot and cold plate, generating higher electrical energy. As will be discussed in greater detail herein, a PCM in the form of, for example, a heat pipe, along with a TEG module and a heat sink arrangement, can be used to harvest energy as shown in FIG. 1, while boosting the electrical energy and enhancing harvesting efficiency.

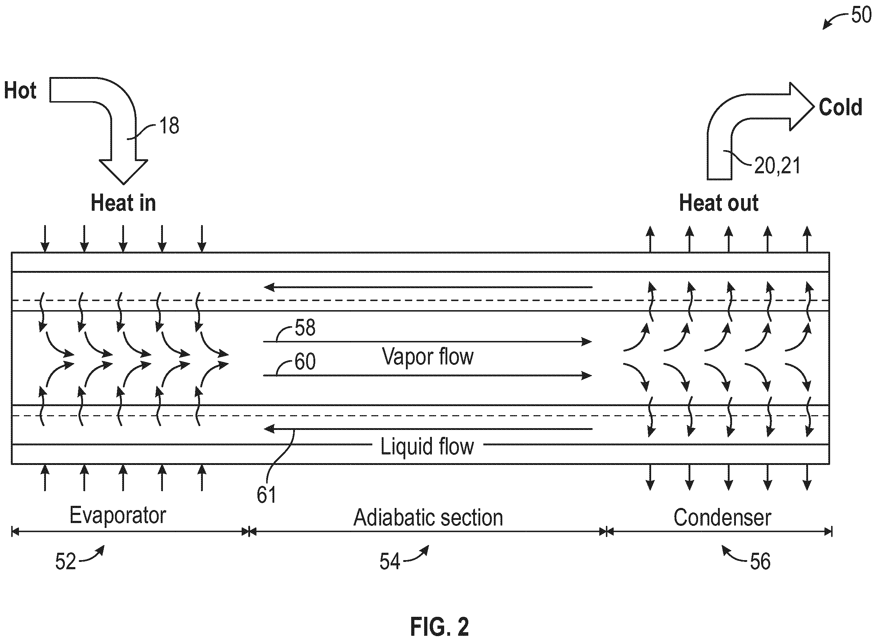

FIG. 2 illustrates a schematic diagram depicting a phase change material (heat pipe) heat exchanger system 50, which may be implemented in accordance with an embodiment. Note that the configuration shown in FIG. 2 may apply to the thermal energy harvesting system 10 depicted in FIG. 1. In FIG. 2 heat 18 is shown as absorbed by the PCM heat exchanger 50 with the cold 20, 21 leaving the PCM heat exchanger system 50. Vapor flow is indicated by arrow 58 and 60 in FIG. 2. Liquid flow is indicated by arrow 61.

The PCM heat exchanger system 50 can be divided into several sections including that of an evaporator 52, an adiabatic section 54, and a condenser 56. The evaporator 52 is analogous to evaporative section or evaporator shown in FIG. 1 The condenser 56 shown in FIG. 2 is analogous or similar to the condensers 14 and 16 shown in FIG. 1. Note that examples of a working fluid for the liquid flow identified in FIG. 2 include, but are not limited to water, ethanol, methanol, sodium, lithium, silver, ammonia, nitrogen and helium.

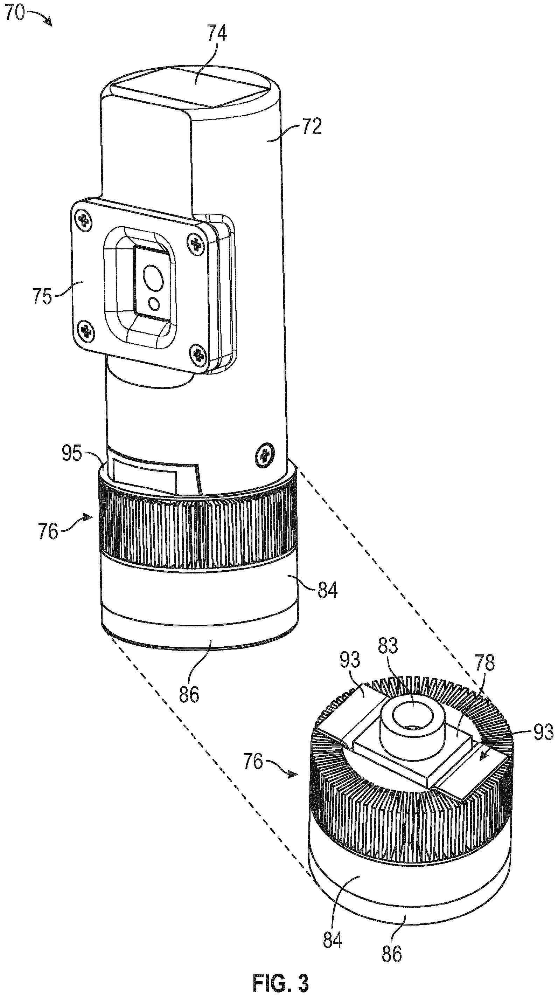

FIG. 3 illustrates a side perspective view of an energy harvesting apparatus 70, which can be implemented in accordance with an embodiment. The energy harvesting apparatus 70 can function as a high-efficient thermo-electric energy harvesting device or system, which may be adapted for use with multi-variant sensor applications, devices and techniques. The energy harvesting apparatus 70 shown in FIG. 3 may function as or may be a multi-variant sensor device in some embodiments.

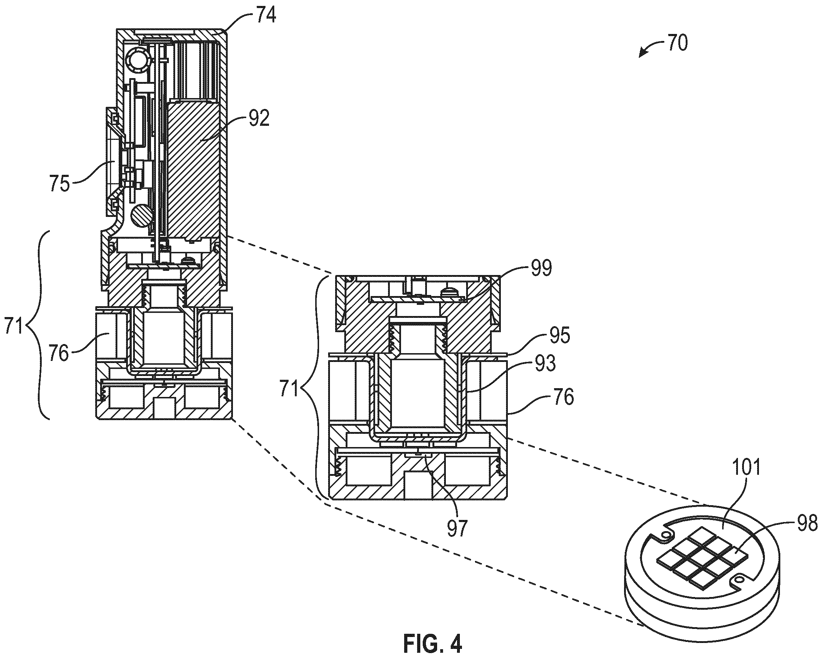

In some embodiments, the energy harvesting apparatus 70 shown in FIG. 3 can implement the configuration of the thermal energy harvesting system 10 shown in FIG. 1 and the PCM heat exchanger 50 depicted in FIG. 2. The energy harvesting apparatus 70 functions based on thermo-electric harvesting due to the use of thermo-electric components such as a TEC integrated circuit (not shown in FIG. 3 but shown in FIG. 4 as TEC IC 98).

The energy harvesting apparatus 70 can be configured with a housing 72 having a generally tubular or cylindrical structure with a photovoltaic panel 74 located at one end of the energy harvesting apparatus 70 and a heat sink 76 and other components generally positioned at the other end of the energy harvesting apparatus 70. The housing 72 may connected to a front lid 75 that can enclose sensors such as an ambient pressure, temperature, humidity and acoustics MEMS sensor. The housing 72 also includes an inset portion 95 that sits above or adjacent to the heat sink 76.

The heat sink 76 is generally circular in shape and is positioned above or next to a section 84 in which additional components such as a temperature sensor 97 (not shown in FIG. 3 but depicted in FIG. 4) can be located. The section 84 sits adjacent a section 86 and the heat sink 76. Note that the heat sink 76 is also shown in a perspective view with a PCM heat exchanger 93 that is located on either side of a plate 78 that connects to a tubular section 83.

FIG. 4 illustrates side sectional views of the energy harvesting apparatus 70 shown in FIG. 3, in accordance with an embodiment. The energy harvesting apparatus 70 can include an energy harvesting section 70 as shown in FIG. 4 to the right of the high-efficient energy harvesting apparatus 70. The photovoltaic panel 74 is shown in FIG. 4 at the top of the high-efficient energy harvesting apparatus 70. A super-cap/battery 92 is located within the high-efficient energy harvesting apparatus 70 and above section 71.

The energy harvesting section 71 includes an interface board 99 and a thermal isolator 95. The thermal isolator 95 is positioned adjacent or proximate to the PCM heat exchanger 93 and extends or runs at least partially within the heat sink 76. Note the general U-shaped arrangement of the PCM heat exchanger 93 and its similarity to the U-shaped configuration of the PCM 12 shown in FIG. 1. The PCM heat exchanger 93 is thus similar or analogous to the PCM 12 of FIG. 1. In addition to inclusion of the heat sink 76 within the energy harvesting section 71, a temperature sensor 97 can be included as a part of and within the energy harvesting section 71. The bottom portion of section 71 is also show in detail including the TEC IC 98, which can be located or mounted on a circular base 101.

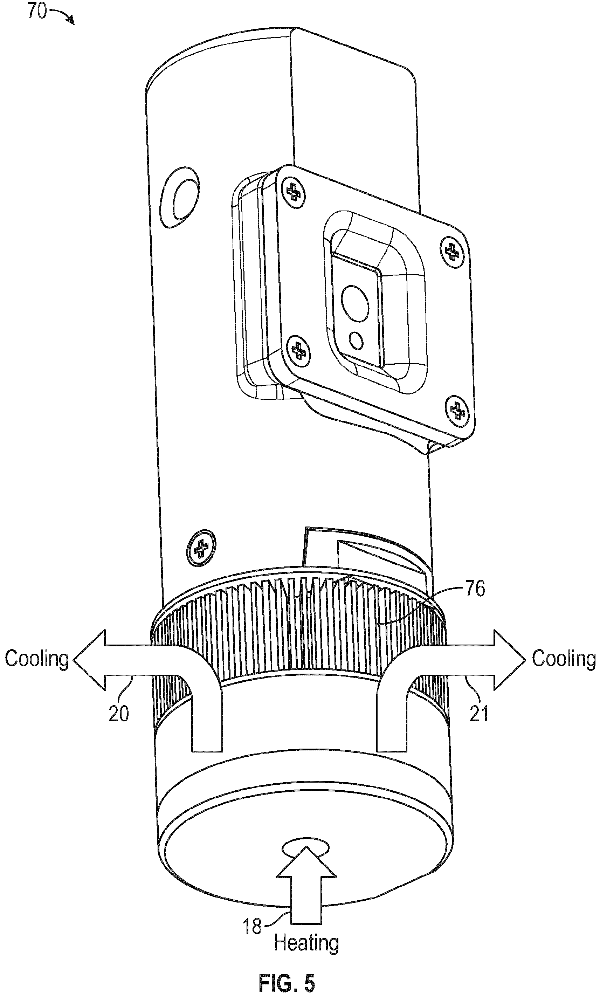

FIG. 5 illustrates a reverse perspective view of an energy harvesting apparatus 70 shown in FIG. 3 and FIG. 4, in accordance with an embodiment. In FIG. 5 cooling or "cold" is indicated by arrows 20 and 21, and heating is indicated by arrow 18.

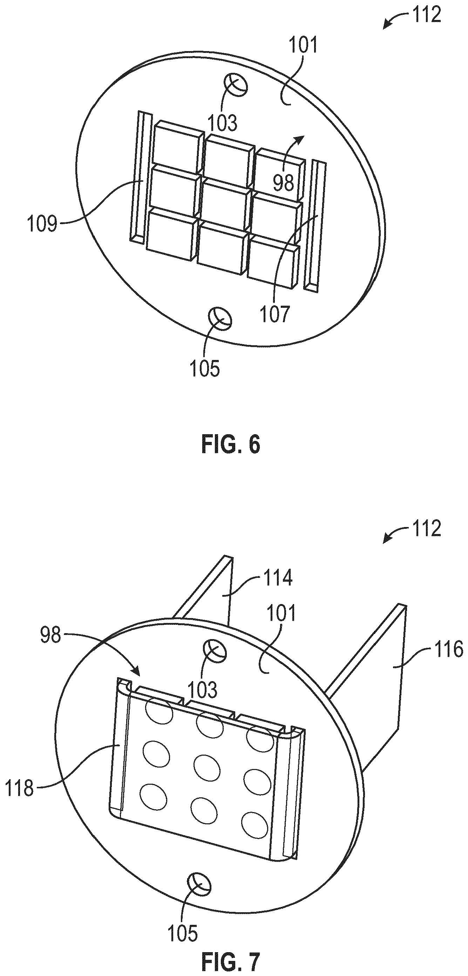

FIG. 6 illustrates an enlarged view of a TEG component 112, in accordance with an embodiment. The TEG integrated circuit (IC) 98 and the circular base 101 can form the TEG component 112. The circular base 101 can include several gaps including mounting holes 103 and 105, which can be used as mounting holes for screws. The circular base 101 can also include rectangular shaped gaps such as slots 107 and 109, which can be used as a slot(s) on the printed circuit board (PCB) to insert the PCM. The TEG component 112 can be implemented as a part of a TEG module.

FIG. 7 illustrates a bottom view of the TEG component 112 shown in FIG. 6 with a PCM heat pipe 118, in accordance with an embodiment. The PCM heat pipe 118 can be attached or connected to the TEG IC 98. In addition, two condenser sections 114 and 116 of the PCM can extend from the backside of the circular base 101. Note that an evaporator section can be attached to the cold plate of the TEG IC 98 to conduct heat from the cold plate to a condenser.

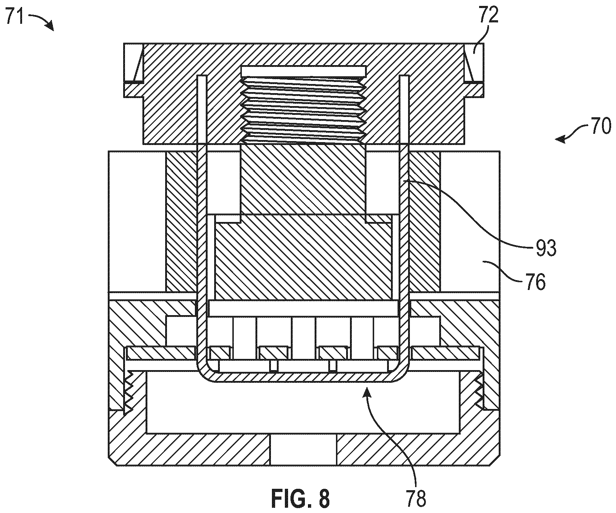

FIG. 8 illustrates a side sectional view of section 71 of the energy harvesting apparatus 70 discussed previously, in accordance with an embodiment. The view shown in FIG. 8 includes a sectional view of the heat sink 76 and the PCM heat exchanger 93.

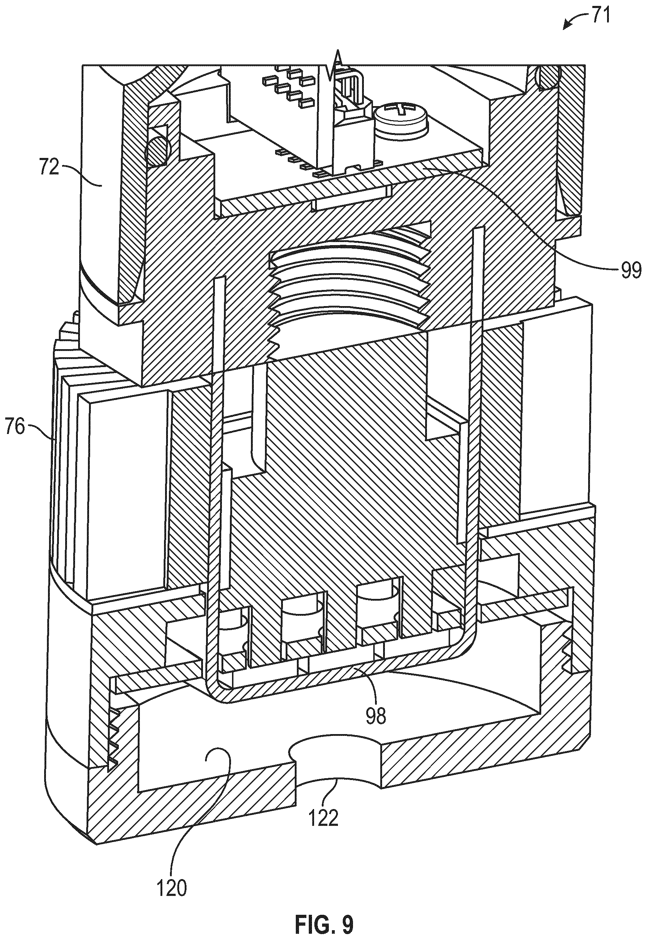

FIG. 9 illustrates a side perspective sectional view of section 71 of the energy harvesting apparatus 70, in accordance with an embodiment. The view shown in FIG. 9 depicts the interface board 99 located within the housing 72 of the energy harvesting apparatus 70. The TEC IC 98 is also depicted in FIG. 9 above a circular gap 120 which surrounds a mounting hole 122 of the energy harvesting apparatus 70

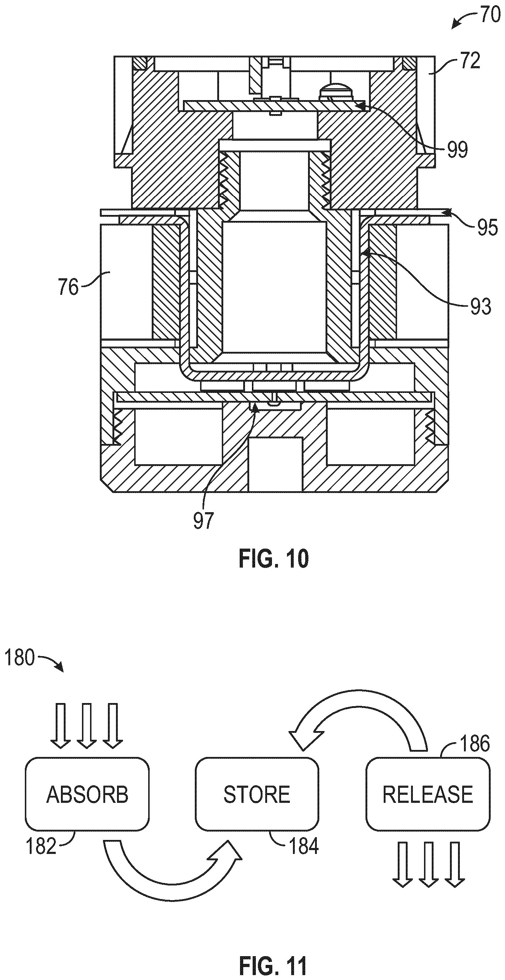

Achieving IP67 with integration is a challenge for these types of systems. Achieving ingress protection (IP67) with such conventional systems is a challenge. These types of systems stand in contradistinction to the systems, systems, and devices shown in the disclosed embodiments. The embodiments described herein incorporate a PCM arrangement that can provide a unique ingress protection (IP67) feature (versus conventional harvester systems such as shown in FIG. 10 and FIG. 11, which require a TEG module outside the housing).

Note that IP67 is a standard for ingress protection, indicating the degree of protection provided by an enclosure against the intrusion of solids and liquids. Specifically, the "IP" stands for "Ingress Protection," and the "67" is the code that defines the level of protection. In the IP67 rating, the "6" refers to the protection against solids, indicating that the device is dust-tight. It offers the highest level of protection against dust and other solid particles. The "7" refers to protection against liquids, indicating that the device is protected against the effects of continuous immersion in water below 1 meter. The exact depth and duration of immersion can vary, so it's important to check the specific details for a particular device. In practical terms, a device with an IP67 rating is considered highly resistant to dust and can be submerged in water for an extended period without being damaged. This rating is often associated with waterproof and dustproof devices, such as certain smartphones and smartwatches, providing users with confidence in using them in various environmental conditions.

FIG. 10 illustrates a side cut-away view of energy harvesting apparatus 70, which may be implemented in accordance with an embodiment. An overall concept of the energy harvesting apparatus 70 revolves around TEG module chipsets that are part of the PCB assembly. Having the TEG modules inside the energy harvesting apparatus 70 and moving the heat sink 76 outside the housing 72 differentiates the disclosed embodiments from conventional harvesting devices/systems.

FIG. 11 illustrates a schematic diagram 180 depicting efficiency in a phase change material (PCM) heat pipe, in accordance with an embodiment. The schematic diagram 180 shown in FIG. 11 includes an absorb phase as shown at block 182 follow by a storage phase as shown at block. 184 and a release phase as shown at block 186. A Phase Change Material (PCM) heat pipe can store thermal energy as shown at block 184 by the phase change from liquid to gaseous (e.g., vapor). This is an advantage, as the latent heat from melting or freezing is at least 1-2 orders of magnitude higher than the energy stored by the specific heat over a representative 10°C change in temperature. This means that the efficiency of the thermal engine of the disclosed TEG harvesting embodiments can generate higher power for a low difference in temperature between hot and cold plates. The efficiency can thus increase by around 50% - 60%.

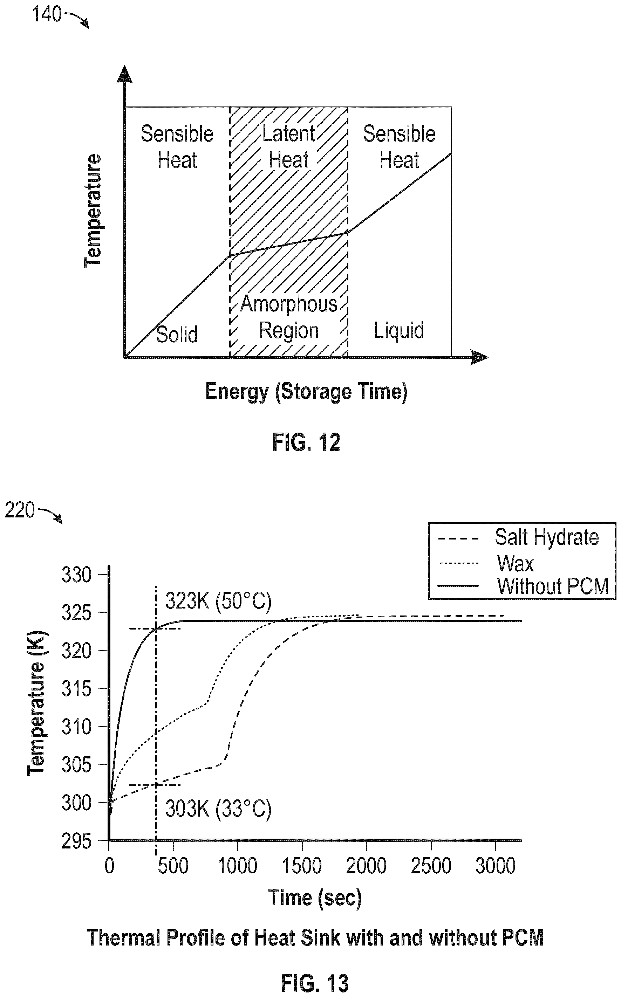

FIG. 12 illustrates graph 140 depicting energy efficiency. Conventional devices such as described earlier use only a TEG module coupled with a heat sink. The heat transfer between a hot plate to a cold plate occurs with natural thermal conduction and convection based on material properties and ambient temperature around. This efficiency is poor compared to the PCM TEG approach of the disclosed embodiments.

The following describes power generation from a heat sink without PCM. Assuming a heat sink with a cross-sectional area 25mm X 25mm with a thermal resistance of 20 K/W for relatively low temperature rise above ambient, let $R_H$ = 0 $K/W$ and Rc= 20 $K/W$. DC-DC converters have electrical load resistances ranging from 2- 12 $\Omega$, and for the calculations

$R_{Load}$= 2.1 (AC) x 1.3 = 2.73 Ω. The minimum DC-DC converter cold start requires, $V_{min}$=50 mV. Table 1 below contains TEG basic information necessary for calculations; typical TE Bi2Te3 material properties near room temperature.

| Parameter | Value | Unit |
|---|---|---|
| Seebeck Coefficient, $\bar{\alpha}$ | 0.00043 | V/K |
| Thermal Conductivity, $k_p, k_n$ | 1.4 | W/m K |
| Electrical Resistivity, $\rho_p, \rho_n$ | 1e-5 | Ω-m |

$$\Delta T_{min} = (4 \times V_{min}) / (N \times \alpha)$$

$$\Delta T_{min} = 4 \times 50mV / 40 \times 0.00043 = \underline{11.63 \text{ degC}}$$

$$V_{TEG} = (N \times \alpha \times (T_{Source} - T_{Ambient})) / 4$$

$$V_{TEG} = 40 \times 0.00043 \times (45 - 25) / 4 = \underline{86 \text{ mV}}$$

$$P_{TEG} = V_{TEG}^2 / R_{Load}$$

$$P_{TEG} = 86 \text{ mV} \times 86mV / 2.73 = 2700uW = \underline{2.7mW @ \Delta T \text{ 20degC}}$$

The above indicates that the generated power is around 2.7mW@20 [0]C delta temperature with TEG energy harvester with heat-sink of size 25mm x 25mm, natural convection; vs required power between 2.2mW to 3mW to power transmitter for 5.5 years (case study).

The following describes power generation from a heat sink with PCM. Assuming PCM with heat sink cross-sectional area 25mm X 25mm and combined thermal resistance of 10 K/W, let $R_H$ = 0 K/W and $R_c$= 10 K/W. From the temperature profile of a heat sink with and without PCM heat pipe, the temperature handling capacity of the heat sink increases because of latent heat; from a case study it is evident that the same size of heat sink can handle twice the thermal power because of the reduced thermal resistance. This means that the heat sink capacity has increased by 2x with PCM heat pipe.

In the previous case of a heat sink without PCM, the power generated is around 2.7mW @ $\Delta T$ 20 [0]C delta temperature. In this case study of a heat sink with PCM, the power generation will double to 5.4mW@ $\Delta T$ 20 [0]C delta temperature. Conversely, the heat sink with PCM reduces the thermal resistance and increases the heat flux capability to generate the same power (previous case) of 2.7mW @ 10 [0]C delta temperature, which means an efficiency increase of 50%. Note that salt hydrates is one of the most common inorganic compounds that can be used as phase change material (PCM). These are available for a wide range of phase transition temperatures.

FIG. 13 illustrates a graph 220 depicting a thermal profile of a heat sink without and without PCM. Generated power is around 2.7mW@10 [0]C delta temperature from a TEG energy harvester, heat-sink of size 25mm x 25mm, with PCM. The efficiency increase of 50% with heat-sink + PCM is compared to only a heat sink.

Based on the foregoing, it should be appreciated that a typical Battery life of a device for every 30min update rate is 5 years. Users are seeking for solutions that are better than 30min, for example every 10min, but in this case the battery life drops down to 1.5 to 2 years. With a limited battery life for around 2 years, replace batteries in the field more often is an expensive proposition. A TEG energy harvesting approach can complement device performance with enhanced update rates down to, for example, 5min, in which case the battery life will last a long time (ideally infinite). The Delta cost of the solution for energy harvesting solution is around $12.

The power consumption of, for example, a Honeywell Versatilis Transmitter (HVT) enabled with BLE and LoRa communication can be 250uW @ 5min sensor update interval and a 30min communication interval. As an example, TEG harvester with a heat sink (without PCM) can deliver 500 to 600uW @ 7 degC. The TEG harvester with a heat sink (with PCM) can deliver 900 to 1400uW @ 10 degC. If the LoRa com interval is reduced to 10min, the power consumption can be 750uW @ 2min sensor update. Considering harvested power vs consumed power, the HVT device can operate ideally infinite for a required communication update rate from, for example, a 10min to 30min interval. This means having a primary battery as a backup, complemented with TEG energy harvesting, can sustain the device operation, for example, > 10 - 15 years.

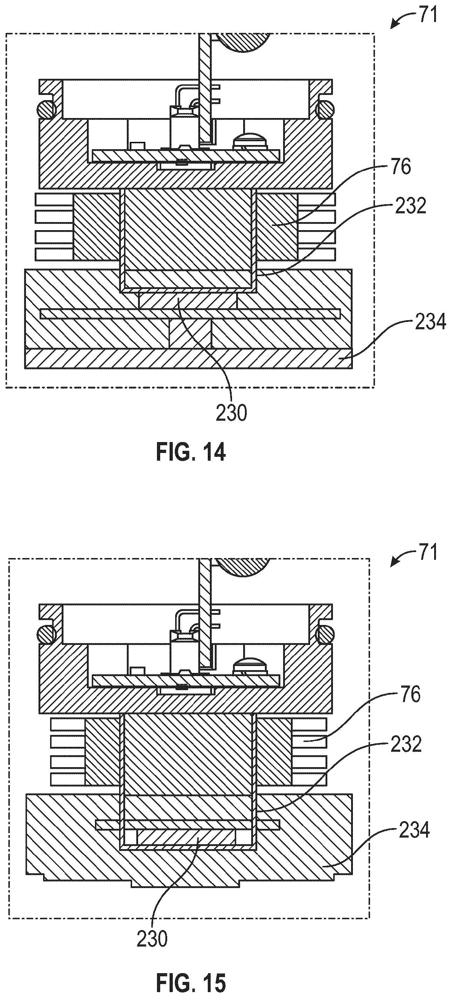

FIG. 14 illustrates a side sectional view of section 71 of the energy harvesting apparatus 70, in accordance with an alternative embodiment. The embodiment shown in FIG. 14 includes the heat sink 76, a PCM heat pipe 232, a TEG module 230, and a hot plate 234.

FIG. 15 illustrates a side sectional view of section 71 of the energy harvesting apparatus 70, in accordance with an alternative embodiment. The embodiment shown in FIG. 15 also includes the heat sink 76, a PCM heat pipe 232, a TEG module 230, and a hot plate 234, but in an arrangement slightly different from that of the configuration shown in FIG. 15.

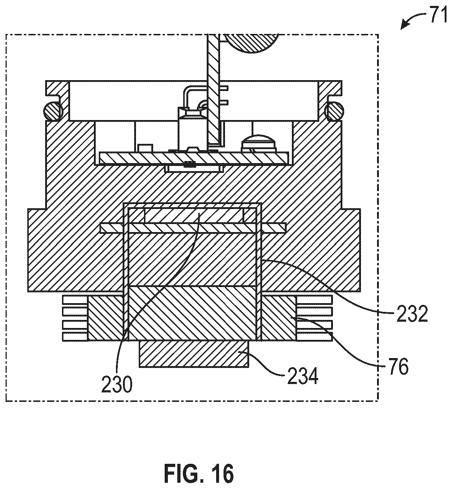

FIG. 16 illustrates a side sectional view of section 71 of the energy harvesting apparatus 70, in accordance with yet another embodiment. The embodiment shown in FIG. 16 also can include the heat sink 76, a PCM heat pipe 232, a TEG module 230, and a hot plate 234, but in an arrangement slightly different from that of the configuration shown in FIG. 14 and FIG. 15. For example, the PCM heat pipe 232 shown in FIG. 16 is reversed from the direction shown for the same feature in FIG. 14 and FIG. 15.

Based on the foregoing, it can be appreciated that a number of different embodiments are disclosed herein. For example, in an embodiment, an energy harvesting system can be implemented, which can include: a phase change material (PCM) heat exchanger and a heat sink, wherein the heat sink is located in an energy harvesting section with the PCM heat exchanger positioned adjacent to the heat sink; and a thermoelectric generator (TEG) module located within the energy harvesting section, wherein heat generated from a heat source is pumped to the heat sink through the TEG module to produce a heat flux/thermal gradient across a hot plate and a cold plate to generate electrical energy.

In an embodiment, the PCM heat exchanger can run from a first condenser to a second condenser.

An embodiment can further include a housing, wherein the heat sink located outside the housing.

In an embodiment, a sensor can be integrated with one or more of: PCM heat exchanger, the heat sink, and the TEG module.

In an embodiment, a sensor can be integrated with the PCM heat exchanger, the heat sink, and the TEG module in a single multi-variant sensor device.

In an embodiment, the single multi-variant sensor device can include ingress protection.

In an embodiment, the sensor can comprise a battery-less self-powered sensor that can harvest free energy from ambient sources using the energy harvesting system.

In an embodiment, the housing can include a cylindrical structure with a photovoltaic panel located at one end of the cylindrical structure and the heat sink located at the other end of the cylindrical structure.

In an embodiment, an energy harvesting system, can include: a first condenser and a second condenser; a phase change material (PCM) heat exchanger and a heat sink, wherein the PCM heat exchanger runs from the first condenser to the second condenser, the heat sink located in an energy harvesting section with the PCM heat exchanger positioned adjacent to the heat sink; and a thermoelectric generator (TEG) module located within the energy harvesting section, wherein heat generated from a heat source is pumped to the heat sink through the TEG module to produce a heat flux/thermal gradient across a hot plate and a cold plate to generate electrical energy.

In an embodiment a method of operating an energy harvesting system, can involve: providing a phase change material (PCM) heat exchanger and a heat sink, wherein the heat sink is located in an energy harvesting section with the PCM heat exchanger positioned adjacent to the heat sink; and pumping heat generated from a heat source to the heat sink through a thermoelectric generator (TEG) module located within the energy harvesting section to produce a heat flux/thermal gradient across a hot plate and a cold plate to generate electrical energy.

In an embodiment of the method, the PCM heat exchanger can run from a first condenser to a second condenser.

An embodiment of the method can further involve operating a sensor integrated with one or more of: PCM heat exchanger, the heat sink, and the TEG module.

An embodiment of the method can also involve operating a sensor integrated with the PCM heat exchanger, the heat sink, and the TEG module in a single multi-variant sensor device.

In an embodiment of the method, the single multi-variant sensor device can include ingress protection, and the sensor can comprise a battery-less self-powered sensor that can harvest free energy from ambient sources using the energy harvesting system.

It will be appreciated that variations of the above-disclosed and other features and functions, or alternatives thereof, may be desirably combined into many other different systems or applications. It will also be appreciated that various presently unforeseen or unanticipated alternatives, modifications, variations or improvements therein may be subsequently made by those skilled in the art which are also intended to be encompassed by the following claims.

**Claims**

**1.** An energy harvesting system, comprising:

a phase change material (PCM) heat exchanger and a heat sink, wherein the heat sink is located in an energy harvesting section with the PCM heat exchanger positioned adjacent to the heat sink;

a thermoelectric generator (TEG) module located within the energy harvesting section, wherein heat generated from a heat source is pumped to the heat sink through the TEG module to produce a heat flux/thermal gradient across a hot plate and a cold plate to generate electrical energy.

2. The energy harvesting system of claim 1 wherein the PCM heat exchanger runs from a first condenser to a second condenser.

3. The energy harvesting system of claim 1 further comprising a housing, wherein the heat sink located outside the housing.

4. The energy harvesting system of claim 1 wherein a sensor is integrated with at least one of: PCM heat exchanger, the heat sink, and the TEG module.

5. The energy harvesting system of claim 1 wherein a sensor is integrated with the PCM heat exchanger, the heat sink, and the TEG module in a single multi-variant sensor device.

6. The energy harvesting system of claim 5 wherein the single multi-variant sensor device comprises ingress protection.

7. The energy harvesting system of claim 5 wherein the sensor comprises a battery-less self-powered sensor harvesting free energy from ambient sources using the energy harvesting system.

8. The energy harvesting system of claim 3 wherein the housing comprises a cylindrical structure with a photovoltaic panel located at one end of the cylindrical structure and the heat sink located at the other end of the cylindrical structure.

9. An energy harvesting system, comprising:

   a first condenser and a second condenser;
   a phase change material (PCM) heat exchanger and a heat sink, wherein the PCM heat exchanger runs from the first condenser to the second condenser, the heat sink located in an energy harvesting section with the PCM heat exchanger positioned adjacent to the heat sink; and
   a thermoelectric generator (TEG) module located within the energy harvesting section, wherein heat generated from a heat source is pumped to the heat sink through the TEG module to produce a heat flux/thermal gradient across a hot plate and a cold plate to generate electrical energy.

10. The energy harvesting system of claim 9 further comprising a housing, wherein the heat sink located outside the housing.

11. The energy harvesting system of claim 9 wherein a sensor is integrated with at least one of: PCM heat exchanger, the heat sink, and the TEG module.

12. The energy harvesting system of claim 9 wherein a sensor is integrated with the PCM heat exchanger, the heat sink, and the TEG module in a single multi-variant sensor device.

13. The energy harvesting system of claim 12 wherein the single multi-variant sensor device comprises ingress protection.

14. A method of operating an energy harvesting system, comprising:

   providing a phase change material (PCM) heat exchanger and a heat sink, wherein the heat sink is located in an energy harvesting section with the PCM heat exchanger positioned adjacent to the heat sink; and
   pumping heat generated from a heat source to the heat sink through a thermoelectric generator (TEG) module located within the energy harvesting section to produce a heat flux/thermal gradient across a hot plate and a cold plate to generate electrical energy.

15. The method of claim 14 wherein the PCM heat exchanger runs from a first condenser to a second condenser.

**FIG. 1**

EP 4 590 107 A1

FIG. 2

FIG. 3

FIG. 4

FIG. 5

**FIG. 6**

**FIG. 7**

71

72

70

93

76

78

FIG. 8

FIG. 9

70

72

99

95

76

93

97

**FIG. 10**

180

ABSORB
182

STORE
184

RELEASE
186

**FIG. 11**

140

**FIG. 12**

220

**Thermal Profile of Heat Sink with and without PCM**

**FIG. 13**

FIG. 14

FIG. 15

**FIG. 16**

Europäisches
Patentamt

European
Patent Office

Office européen
des brevets

# EUROPEAN SEARCH REPORT

**Application Number**

EP 25 15 0331

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 160 887 A2 (HONEYWELL INT INC [US]) 5 April 2023 (2023-04-05) * paragraph [0051] - paragraph [0056]; figures 2-3 * | 1-15 | INV. H10N10/13 H10N10/17 |
| A | EP 3 783 277 A1 (UNIV NAVARRA PUBLICA [ES]) 24 February 2021 (2021-02-24) * paragraph [0015] - paragraph [0017]; figures 1,2 * | 1-15 | |

TECHNICAL FIELDS SEARCHED (IPC)

H10N

The present search report has been drawn up for all claims

| Place of search | Date of completion of the search | Examiner |
|---|---|---|
| The Hague | 9 May 2025 | Kirkwood, Jonathan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 0331

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2025

| Patent document cited in search report | | Publication date | Patent family member(s) | | Publication date |
|---|---|---|---|---|---|
| EP 4160887 | A2 | 05-04-2023 | CA | 3172597 A1 | 08-03-2023 |
| | | | CN | 115776211 A | 10-03-2023 |
| | | | EP | 4160887 A2 | 05-04-2023 |
| | | | US | 2023074890 A1 | 09-03-2023 |
| EP 3783277 | A1 | 24-02-2021 | EP | 3783277 A1 | 24-02-2021 |
| | | | ES | 3006479 T3 | 18-03-2025 |
| | | | PT | 3783277 T | 21-01-2025 |
| | | | WO | 2019202180 A1 | 24-10-2019 |

EPO FORM P0459

For more details about this annex : see Official Journal of the European Patent Office, No. 12/82